(19) Europäisches Patentamt
European Patent Office
Office européen des brevets

(11) **EP 2 703 122 A2**

(12) **EUROPEAN PATENT APPLICATION**

(43) Date of publication:
**05.03.2014 Bulletin 2014/10**

(51) Int Cl.:
***B24B 37/30*** *(2012.01)*

(21) Application number: **13020084.3**

(22) Date of filing: **27.08.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.08.2012 JP 2012187118**
**12.08.2013 JP 2013167273**

(71) Applicant: **EBARA CORPORATION**
**Ohta-ku,**
**Tokyo (JP)**

(72) Inventors:
• **Fukushima, Makoto**
**Tokyo (JP)**
• **Yasuda, Hozumi**
**Tokyo (JP)**
• **Nabeya, Osamu**
**Tokyo (JP)**
• **Togashi, Shingo**
**Tokyo (JP)**

(74) Representative: **Emde, Eric**
**Wagner & Geyer**
**Gewürzmühlstrasse 5**
**80538 München (DE)**

(54) **Elastic membrane and substrate holding apparatus**

(57) An elastic membrane is used in a substrate holding apparatus for holding a substrate such as a semiconductor wafer and presseing the substrate against a polishing surface. The elastic membrane includes a plurality of concentrically circumferential walls configured to define a plurality of pressurizing areas for pressing the substrate. The pressurizing areas includes a central pressurizing area located at a central part of the elastic membrane, an annular edge pressurizing area located at the outermost part of the elastic membrane, and a plurality of intermediate pressurizing areas located between the central pressurizing area and the annular edge pressurizing area. The area width of at least one of the intermediate pressurizing areas is set in a range to allow a polishing rate responsive width not to vary even when the area width is varied.

FIG. 1

EP 2 703 122 A2

## Description

BACKGROUND OF THE INVENTION

Field of the Invention:

The present invention relates to an elastic membrane for use in a substrate holding apparatus for holding a substrate such as a semiconductor wafer and pressing the substrate against a polishing surface in a polishing apparatus for polishing and planarizing the substrate. Further, the present invention relates to a substrate holding apparatus having such elastic membrane.

Description of the Related Art:

In recent years, high integration and high density in semiconductor device demands smaller and smaller wiring patterns or interconnections and also more and more interconnection layers. Multilayer interconnections in smaller circuits result in greater steps which reflect surface irregularities on lower interconnection layers. An increase in the number of interconnection layers makes film coating performance (step coverage) poor over stepped configurations of thin films. Therefore, better multilayer interconnections need to have the improved step coverage and proper surface planarization. Further, since the depth of focus of a photolithographic optical system is smaller with miniaturization of a photolithographic process, a surface of the semiconductor device needs to be planarized such that irregular steps on the surface of the semiconductor device will fall within the depth of focus.

Thus, in a manufacturing process of a semiconductor device, it increasingly becomes important to planarize a surface of the semiconductor device. One of the most important planarizing technologies is chemical mechanical polishing (CMP). In the chemical mechanical polishing, while a polishing liquid containing abrasive particles such as silica ($SiO_2$) therein is supplied onto a polishing surface such as a polishing pad, a substrate such as a semiconductor wafer is brought into sliding contact with the polishing surface and polished using the polishing apparatus.

This kind of polishing apparatus includes a polishing table having a polishing surface formed by a polishing pad, and a substrate holding apparatus for holding a substrate such as a semiconductor wafer. When the semiconductor wafer is polished with such a polishing apparatus, the semiconductor wafer is held and pressed against the polishing surface under a predetermined pressure by the substrate holding apparatus. At this time, the polishing table and the substrate holding apparatus are moved relative to each other to bring the semiconductor wafer into sliding contact with the polishing surface, so that the surface of the semiconductor wafer is polished to a flat mirror finish.

In such polishing apparatus, if a polishing rate of the semiconductor wafer is not uniform over the entire surface of the semiconductor wafer, then the semiconductor wafer is insufficiently or excessively polished depending on the polishing rate of each area of the semiconductor wafer. Therefore, there has been known a polishing apparatus in which a plurality of concentric pressure chambers defined by an elastic membrane are provided at a lower portion of the substrate holding apparatus, and by controlling pressures of pressurized fluid supplied to the respective pressure chambers, the semiconductor wafer is pressed against the polishing surface under different pressures at respective pressurizing areas, along a radial direction of the semiconductor wafer, corresponding to the respective pressure chambers.

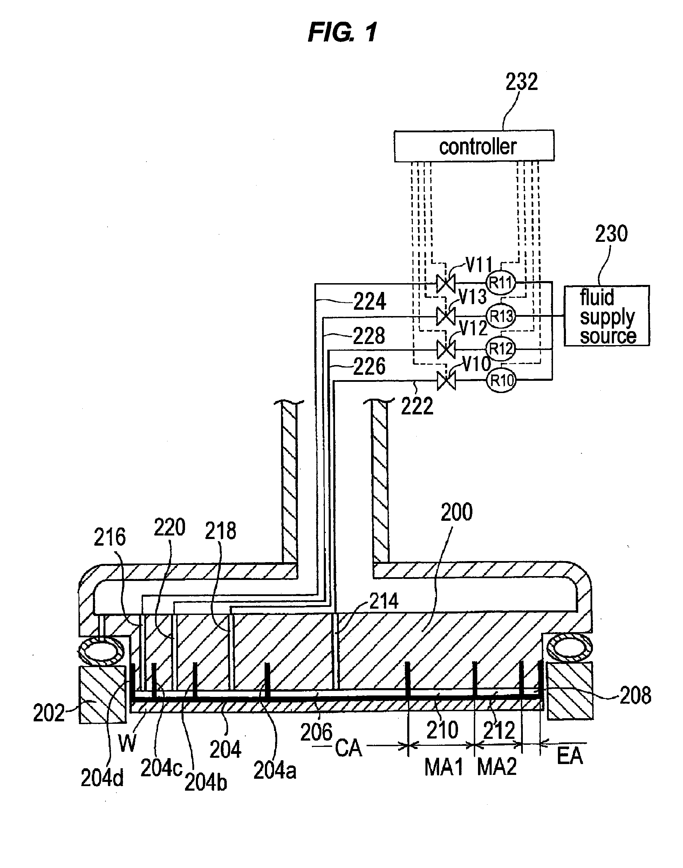

FIG. 1 shows an example of a substrate holding apparatus of the above polishing apparatus. As shown in FIG. 1, the substrate holding apparatus has an apparatus body 200, a retainer ring 202, and an elastic membrane 204 provided on a lower surface of the apparatus body 200. On an upper surface of the elastic membrane 204, a plurality of (four in the figure) concentric circumferential walls 204a, 204b, 204c and 204d are provided. By these concentric circumferential walls 204a, 204b, 204c and 204d, a circular central pressure chamber 206 located at a central part of the semiconductor wafer W, an annular edge pressure chamber 208 located at the outermost part of the semiconductor wafer W, and two annular intermediate pressure chambers 210, 212 located between the central pressure chamber 206 and the edge pressure chamber 208 are formed between the upper surface of the elastic membrane 204 and the lower surface of the apparatus body 200.

With this configuration, the semiconductor wafer W is held by the substrate holding apparatus in such a state that there are four divided pressurizing areas, on the elastic membrane 204, comprising a circular central pressurizing area CA corresponding to the central pressure chamber 206, an annular edge pressurizing area EA corresponding to the edge pressure chamber 208, and two annular intermediate pressurizing areas MA1, MA2 corresponding to the intermediate pressure chambers 210, 212.

In the apparatus body 200, a passage 214 communicating with the central pressure chamber 206, a passage 216 communicating with the edge pressure chamber 208, and passages 218, 220 communicating respectively with the intermediate pressure chambers 210, 212 are formed. The respective passages 214, 216, 218 and 220 are connected via respective passages 222, 224, 226 and 228 to a fluid supply source 230. Further, opening and closing valves V10,V11,V12 and V 13 and pressure regulators R10, R11, R12 and R13 are provided in the passages 222, 224, 226 and 228, respectively.

The respective pressure regulators R10, R11, R12 and R13 have pressure adjusting function for adjusting pressures of pressurized fluid to be supplied from the fluid supply source 230 to the respective pressure chambers 206, 208, 210 and 212. The pressure regulators R10, R11, R12 and R13 and the opening and closing valves V10, V11, V12 and V13 are connected to a controller 232, and operations of these pressure regulators and these valves are controlled by the controller 232.

With this arrangement, by controlling respective pressures of the pressurized fluid to be supplied to the respective pressure chambers 206, 208, 210 and 212 in such a state that the semiconductor wafer W is held by the substrate holding apparatus, the semiconductor wafer W can be pressed against the polishing surface (not shown) under different pressures at the respective pressurizing areas CA, EA, MA1 and MA2 on the elastic membrane 204 along a radial direction of the semiconductor wafer W.

In order to transmit the fluid pressures of the pressure chambers 206, 208, 210 and 212 defined on the upper surface of the elastic membrane 204 toward the semiconductor wafer W efficiently and to press the semiconductor wafer under a uniform pressure from the central part to the edge part of the semiconductor wafer W, a flexible material such as rubber is generally used for the elastic membrane 204.

In the case where a substrate such as a semiconductor wafer is held and pressed against the polishing surface to be polished by such substrate holding apparatus, if different pressures of the pressurized fluid are applied to two adjacent pressure chambers, then there occurs a step-like difference in pressing pressures (polishing pressures) for pressing the substrate in two adjacent pressurizing areas. As a result, a step-like height difference is produced also in polishing configuration (polishing profile). In this case, if there is a large pressure difference in pressures of the pressurized fluid supplied to the two adjacent pressure chambers, the step-like height difference in polishing configuration (polishing profile) becomes larger depending on the pressure difference in pressures for pressing the substrate in the two adjacent pressurizing areas.

Therefore, the applicant of the present invention has proposed to provide a diaphragm onto the elastic membrane so as to exist on both sides of the boundary between the two adjacent pressure chambers, the diaphragm being composed of a material having higher rigidity (large modulus of longitudinal elasticity) than the elastic membrane, as disclosed in Japanese laid-open patent publication No. 2009-131920.

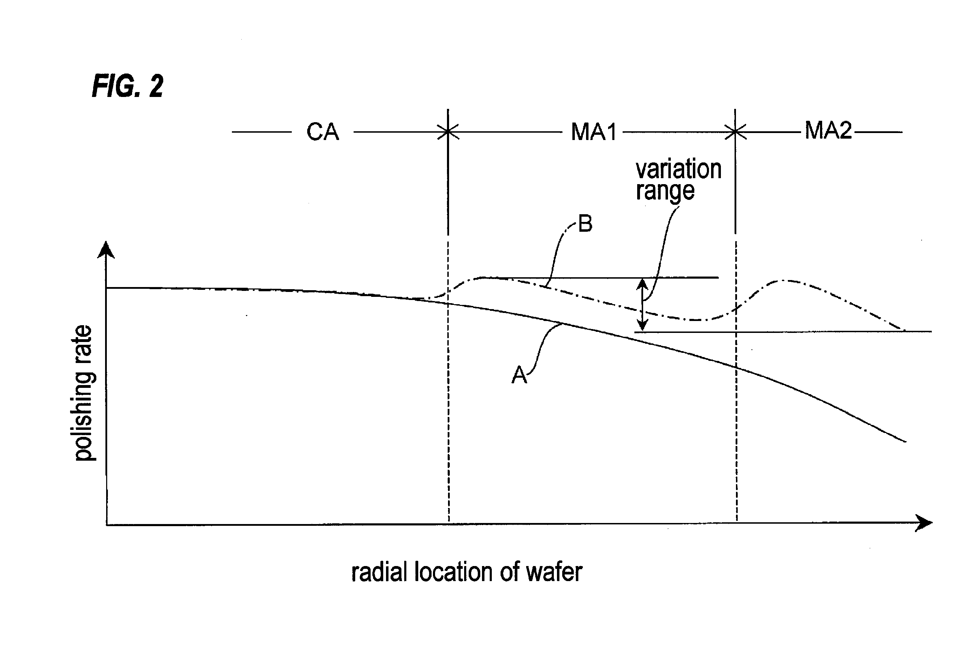

FIG. 2 is a graph showing the relationship between locations along a radial direction of a semiconductor wafer and a polishing rate when the semiconductor wafer is held and polished by the substrate holding apparatus shown in FIG. 1, while the pressures of the pressurized fluid supplied to the respective pressure chambers 206, 208, 210 and 212 are equalized. As shown by a solid line A in FIG. 2, there are cases where the polishing rate is gradually decreased toward a radially outward direction of the semiconductor wafer. With respect to radial locations of the semiconductor wafer in FIG. 2, the areas CA, MA1 and MA2 along a radial direction of the semiconductor wafer correspond to respective pressurizing areas CA, MA1 and MA2 on the elastic membrane 204 shown in FIG. 1.

In such case, when the pressures of the pressurized fluid supplied to the intermediate pressure chambers 210, 212 are increased to increase the polishing rate in the areas of the semiconductor wafer corresponding to the intermediate pressurizing areas MA1, MA2, as shown by a dotted-dashed line B in FIG. 2, the polishing rate in the areas corresponding to the intermediate pressurizing areas MA1, MA2 is increased as a whole, but the inclination of the polishing rate in the intermediate pressurizing areas MA1, MA2 is substantially the same as the inclination of the polishing rate shown by the solid line A showing the case where the pressures of the pressurized fluid supplied to the intermediate pressure chambers 210, 212 are not increased. That is, the polishing rate in the intermediate pressurizing areas MA1, MA2 is increased in parallel at approximately the same rate while keeping the inclination of the polishing rate approximately constant.

Accordingly, the range of polishing rate distribution (variation range of polishing rate) over the entire surface of the semiconductor wafer is narrowed, however the range of polishing rate distribution (variation range of polishing rate) along a radial direction of the semiconductor wafer in the respective pressurizing areas, e.g. in the intermediate pressurizing area MA1, is not narrowed even when the pressure of the pressurized fluid is increased. Therefore, by the size of the radial area width of the pressurizing area MA1, the enhancement of uniformity of the surface, being polished, of the semiconductor wafer is hindered and the improvement of yield is limited.

SUMMARY OF THE INVENTION

The present invention has been made in view of the above circumstances. It is therefore an object of the present invention to provide an elastic membrane for use in a substrate holding apparatus of a polishing apparatus which can narrow the range of polishing rate distribution (variation range of polishing rate) in areas of a substrate corresponding to pressurizing areas concentrically disposed along a radial direction of the substrate, thus enhancing uniformity of a surface, being polished, of the substrate and improving yield. Further, it is another object of the present invention to provide a substrate holding apparatus having such elastic membrane.

In order to achieve the above object, according to an aspect of the present invention, there is provided an elastic membrane for use in a substrate holding apparatus for holding a substrate, the elastic membrane comprising: a plurality of concentrically circumferential walls configured to define a plurality of pressurizing areas for pressing the substrate, the plurality of pressurizing areas comprising a central pressurizing area located at a central part of the elastic membrane, an annular edge pressurizing area located at the outermost part of the elastic membrane, and a plurality of intermediate pressurizing areas located between the central pressurizing area and the annular edge pressurizing area; wherein a radial area width of at least one of the intermediate pressurizing areas is set in a range to allow a polishing rate responsive width not to vary even when the radial area width is varied.

Hereinafter, the radial area width of each of the pressurizing areas may be simply referred to as an area width.

The polishing rate responsive width corresponds to a radial area of the substrate determined in each of the plurality of intermediate pressurizing areas; and an absolute value of variation between a polishing rate when the substrate is polished under certain pressure condition and a polishing rate when the substrate is polished under pressure condition changed by a predetermined pressure from the certain pressure condition in each of the intermediate pressurizing areas is calculated, and the radial area of the substrate in which the absolute value of the polishing rate variation is not less than 20% and not more than 100% with respect to a maximum absolute value of the polishing rate variation in each of the intermediate pressurizing areas is defined as the polishing rate responsive width.

Examples of the above certain pressure condition include pressure condition adjusted such that the polishing rates in the respective intermediate pressurizing areas are equalized, but are not necessarily required to be pressures adjusted by constant condition.

According to the present invention, the at least one of the intermediate pressurizing areas whose area width is set in the range to allow the polishing rate responsive width not to vary even when the area width is varied, comprises at least two of the plurality of intermediate pressurizing areas which are adjacent to each other.

With such configuration, by setting the area width of at least one of the plurality of intermediate pressurizing areas, e.g. at least two of the plurality of intermediate pressurizing areas adjacent to each other, in the range to allow the polishing rate responsive width not to vary even when the area width is varied, the range of polishing rate distribution (variation range of polishing rate) in the intermediate pressurizing area whose area width has been set in such a manner can be narrowed to enhance uniformity of a surface, being polished, of the substrate and improve yield.

When the elastic membrane is used for a substrate holding apparatus for holding a semiconductor wafer having a diameter of 300mm, the area width of at least one of the intermediate pressurizing areas or at least two of the intermediate pressurizing areas which are adjacent to each other, is preferably set in a range of not less than 2mm and not more than 15mm.

When the elastic membrane is used for a substrate holding apparatus for holding a semiconductor wafer having a diameter of 300mm, the area width of at least one of the intermediate pressurizing areas located at an outer circumferential side may be set in a range of not less than 2mm and not more than 15mm, and the area width of the intermediate pressurizing area located at a radially inner side of the intermediate pressurizing area having the area width set in a range of not less than 2mm and not more than 15mm, may be set in a range of not less than 2mm and not more than 20mm.

When the elastic membrane is used for a substrate holding apparatus for holding a semiconductor wafer having a diameter of 450mm, the area width of at least one of the intermediate pressurizing areas or at least two of the intermediate pressurizing areas which are adjacent to each other, is preferably set in a range of not less than 2mm and not more than 26mm.

When the elastic membrane is used for a substrate holding apparatus for holding a semiconductor wafer having a diameter of 450mm, the area width of at least one of the intermediate pressurizing areas located at an outer circumferential side may be set in a range of not less than 2mm and not more than 26mm, and the area width of the intermediate pressurizing area located at a radially inner side of the intermediate pressurizing area having the area width set in the range of not less than 2mm and not more than 26mm, may be set in a range of not less than 2mm and not more than 34mm.

According to another aspect of the present invention, there is provided an elastic membrane for use in a substrate holding apparatus for holding a semiconductor wafer having a thickness t ($\mu$m), Young's modulus E (MPa), the elastic membrane comprising: a plurality of concentrically circumferential walls configured to define a plurality of pressurizing areas for pressing the semiconductor wafer, the plurality of pressurizing areas comprising a central pressurizing area located at a central part of the elastic membrane, an annular edge pressurizing area located at the outermost part of the elastic membrane, and a plurality of intermediate pressurizing areas located between the central pressurizing area and the annular edge pressurizing area; wherein an area width of at least one of the intermediate pressurizing areas is set in a range to allow a polishing rate responsive width not to vary even when the area width is varied; and the area width of the at least one of the intermediate pressurizing areas is set in the range of not less than 2mm and not more than EWb (mm) defined in the following formula;

$$EWb=15\times(t/775)^3\times(E/194000).$$

According to another aspect of the present invention, there is provided a substrate holding apparatus for holding a substrate to be polished and pressing the substrate against a polishing surface, comprising: an elastic membrane; an apparatus body for holding the elastic membrane; a plurality of pressure chambers partitioned by a plurality of concentrically circumferential walls of the elastic membrane between the elastic membrane and a lower surface of the apparatus body, the substrate being held by a lower surface of the elastic membrane and being pressed against the polishing surface with a fluid pressure by supplying a pressurized fluid to the plurality of pressure chambers; the plurality of concentrically circumferential walls being configured to define a plurality of pressurizing areas for pressing the substrate, the plurality of pressurizing areas comprising a central pressurizing area located at a central part of the elastic membrane, an annular edge pressurizing area located at the outermost part of the elastic membrane, and a plurality of intermediate pressurizing areas located between the central pressurizing area and the annular edge pressurizing area; wherein an area width of at least one of the intermediate pressurizing areas is set in a range to allow a polishing rate responsive width not to vary even when the area width is varied.

According to another aspect of the present invention, there is provided a substrate holding apparatus for holding a semiconductor wafer having a thickness t ($\mu$m), Young's modulus E (MPa) and pressing the semiconductor wafer against a polishing surface, comprising: an elastic membrane; an apparatus body for holding the elastic membrane; a plurality of pressure chambers partitioned by a plurality of concentrically circumferential walls of the elastic membrane between the elastic membrane and a lower surface of the apparatus body, the semiconductor wafer being held by a lower surface of the elastic membrane and being pressed against the polishing surface with a fluid pressure by supplying a pressurized fluid to the plurality of pressure chambers; the plurality of concentrically circumferential walls being configured to define a plurality of pressurizing areas for pressing the semiconductor wafer, the plurality of pressurizing areas comprising a central pressurizing area located at a central part of the elastic membrane, an annular edge pressurizing area located at the outermost part of the elastic membrane, and a plurality of intermediate pressurizing areas located between the central pressurizing area and the annular edge pressurizing area; wherein an area width of at least one of the intermediate pressurizing areas is set in a range to allow a polishing rate responsive width not to vary even when the area width is varied; and the area width of the at least one of the intermediate pressurizing areas is set in the range of not less than 2mm and not more than EWb (mm) defined in the following formula; $EWb=15\times(t/775)^3\times(E/194000)$.

According to the elastic membrane of the present invention, the elastic membrane is used in the substrate holding apparatus of the polishing apparatus for polishing the surface of the substrate, and thus the range of polishing rate distribution (variation range of polishing rate) between a plurality of pressurizing areas defined by the elastic membrane and also in the respective pressurizing areas can be narrowed to enhance the uniformity of the surface, being polished, of the substrate and improve yield.

BRIEF DESCRIPTION OF THE DRAWINGS

FIG. 1 is a schematic view showing a conventional substrate holding apparatus;
FIG. 2 is a graph showing the relationship between locations along a radial direction of a semiconductor wafer and a polishing rate when the semiconductor wafer is held and polished by the substrate holding apparatus shown in FIG. 1;
FIG. 3 is a schematic view showing an entire structure of a polishing apparatus having a substrate holding apparatus according to the present invention;
FIG. 4 is a schematic view showing the substrate holding apparatus provided in the polishing apparatus shown in FIG. 3;
FIG. 5 is a graph showing the relationship between a polishing rate (arbitrary unit) and locations along a radial direction of the semiconductor wafer when the semiconductor wafer is polished by using the polishing apparatus shown in FIG. 3, in the case where pressures of pressurized fluid supplied to respective pressure chambers are substantially equalized and the case where only a pressure of pressurized fluid supplied to one pressure chamber is increased by 20hPa;
FIG. 6 is a graph for explanation of a definition of a polishing rate responsive width of a pressurizing area;
FIG. 7 is a graph showing the relationship between area widths of the pressurizing areas and the polishing rate responsive widths;
FIG. 8 is a view showing the relationship between intermediate pressurizing areas and polishing rate responsive widths corresponding to the intermediate pressurizing areas, in the case where three intermediate pressurizing areas having relatively wide area widths are adjacent to each other;

FIG. 9 is a view showing the relationship between intermediate pressurizing areas and polishing rate responsive widths corresponding to the intermediate pressurizing areas, in the case where three intermediate pressurizing areas having relatively narrow area widths are adjacent to each other;

FIG. 10 is a view showing the relationship between intermediate pressurizing areas and polishing rate responsive widths corresponding to the intermediate pressurizing areas, in the case where an intermediate pressurizing area having a relatively narrow area width is located between two adjacent intermediate pressurizing areas having relatively wide area widths;

FIG. 11 is a graph showing the relationship between the area widths of the pressurizing areas and the polishing rate responsive widths;

FIG. 12 is a view for explanation of an overlap ratio of polishing rate response in the case where intermediate pressurizing areas, whose area widths are 20mm and polishing rate responsive widths are 30mm, are adjacent to each other;

FIG. 13 is a view for explanation of an overlap ratio of polishing rate response in the case where intermediate pressurizing areas, whose area widths are 10mm and polishing rate responsive widths are 25mm, are adjacent to each other;

FIG. 14 is a graph showing the relationship between the area widths of the pressurizing areas and the overlap ratios of polishing rate response; and

FIG. 15 is a graph showing the relationship between radial locations of the semiconductor wafer and a polishing rate when the semiconductor wafer having a diameter of 300mm is polished by using the polishing apparatus shown in FIG. 3.

## DETAILED DESCRIPTION OF THE PREFERRED EMBODIMENTS

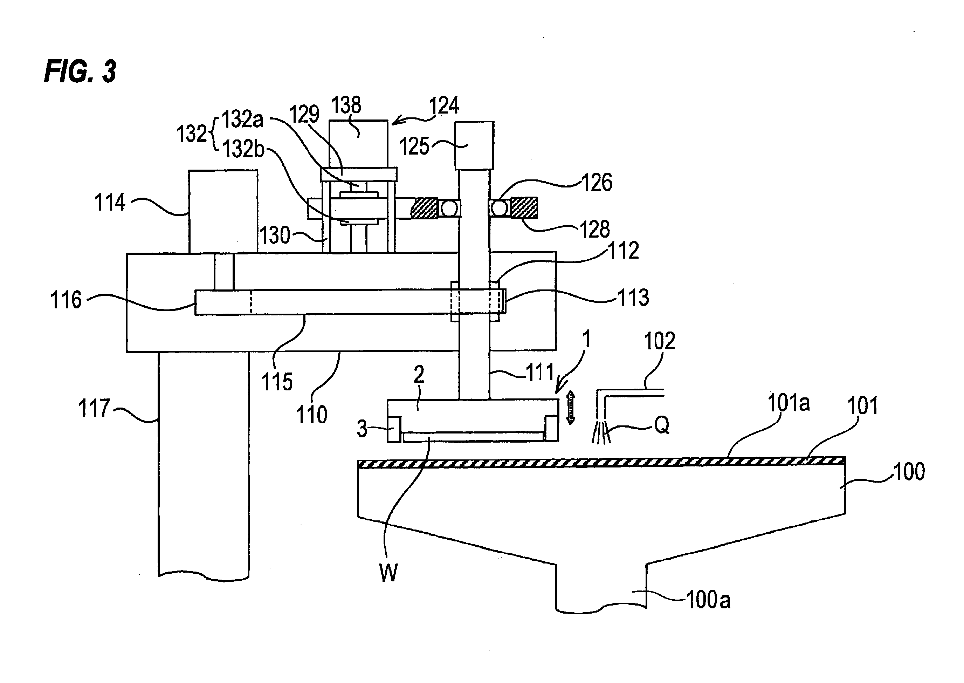

Embodiments of the present invention will be described below with reference to FIGS. 3 through 15. In the following examples, a semiconductor wafer having a diameter of 300mm and a thickness of $775\pm25\mu m$ is used as a substrate. Young's modulus (MPa) of the semiconductor wafer is 194000.

FIG. 3 is a schematic view showing an entire structure of a polishing apparatus having a substrate holding apparatus according to the present invention. As shown in FIG. 3, the polishing apparatus comprises a polishing table 100, and a substrate holding apparatus 1 for holding a semiconductor wafer (substrate) W having a diameter of 300mm as an object to be polished and pressing the semiconductor wafer against a polishing surface on the polishing table 100. The polishing table 100 is coupled via a table shaft 100a to a motor (not shown) disposed below the polishing table 100. Thus, the polishing table 100 is rotatable about the table shaft 100a. A polishing pad 101 is attached to an upper surface of the polishing table 100. An upper surface of the polishing pad 101 constitutes a polishing surface 101a to polish a semiconductor wafer W. A polishing liquid supply nozzle 102 is provided above the polishing table 100 to supply a polishing liquid Q onto the polishing surface 101a of the polishing pad 101 on the polishing table 100.

The substrate holding apparatus 1 is connected to a main shaft 111, which is vertically movable with respect to a polishing head 110 by a vertically moving mechanism 124. By vertical movement of the main shaft 111, the substrate holding apparatus 1 is lifted and lowered as a whole for positioning with respect to the polishing head 110. A rotary joint 125 is mounted on the upper end of the main shaft 111.

The vertically moving mechanism 124 for vertically moving the main shaft 111 and the substrate holding apparatus 1 comprises a bridge 128 on which the main shaft 111 is rotatably supported by a bearing 126, a ball screw 132 mounted on the bridge 128, a support base 129 supported by support posts 130, and an AC servomotor 138 mounted on the support base 129. The support base 129, which supports the AC servomotor 138 thereon, is fixedly mounted on the polishing head 110 by the support posts 130.

The ball screw 132 comprises a screw shaft 132a coupled to the AC servomotor 138 and a nut 132b threaded over the screw shaft 132a. The main shaft 111 is vertically movable in unison with the bridge 128 by the vertically moving mechanism 124. When the AC servomotor 138 is energized, the bridge 128 moves vertically via the ball screw 132, and the main shaft 111 and the substrate holding apparatus 1 move vertically.

The main shaft 111 is connected to a rotary sleeve 112 by a key (not shown). The rotary sleeve 112 has a timing pulley 113 fixedly disposed therearound. A motor 114 having a drive shaft is fixed to the polishing head 110. The timing pulley 113 is operatively coupled to a timing pulley 116 mounted on the drive shaft of the motor 114 by a timing belt 115. When the motor 114 is energized, the timing pulley 116, the timing belt 115, and the timing pulley 113 are rotated to rotate the rotary sleeve 112 and the main shaft 111 in unison with each other, thus rotating the substrate holding apparatus 1. The polishing head 110 is supported on a head shaft 117 rotatably supported on a frame (not shown).

In the polishing apparatus constructed as shown in FIG. 3, the substrate holding apparatus 1 is configured to hold the semiconductor wafer (substrate) W on its lower surface. The polishing head 110 is pivotable (swingable) about the head shaft 117. Thus, the substrate holding apparatus 1, which holds the semiconductor wafer W on its lower surface, is moved between a position at which the substrate holding apparatus 1 receives the semiconductor wafer W and a position above the polishing table 100 by pivotal movement of the polishing head 110. The substrate holding apparatus 1 is lowered to press the semiconductor wafer W against the polishing surface 101 a of the polishing pad 101. At this time, while the substrate holding apparatus 1 and the polishing table 100 are respectively rotated, a polishing liquid Q is supplied onto the polishing surface 101a of the polishing pad 101 by the polishing liquid supply nozzle 102 provided above the polishing table 100. The semiconductor wafer W is brought into sliding contact with the polishing surface 101a of the polishing pad 101 in the presence of the polishing liquid Q. Thus, a surface of the semiconductor wafer W is polished.

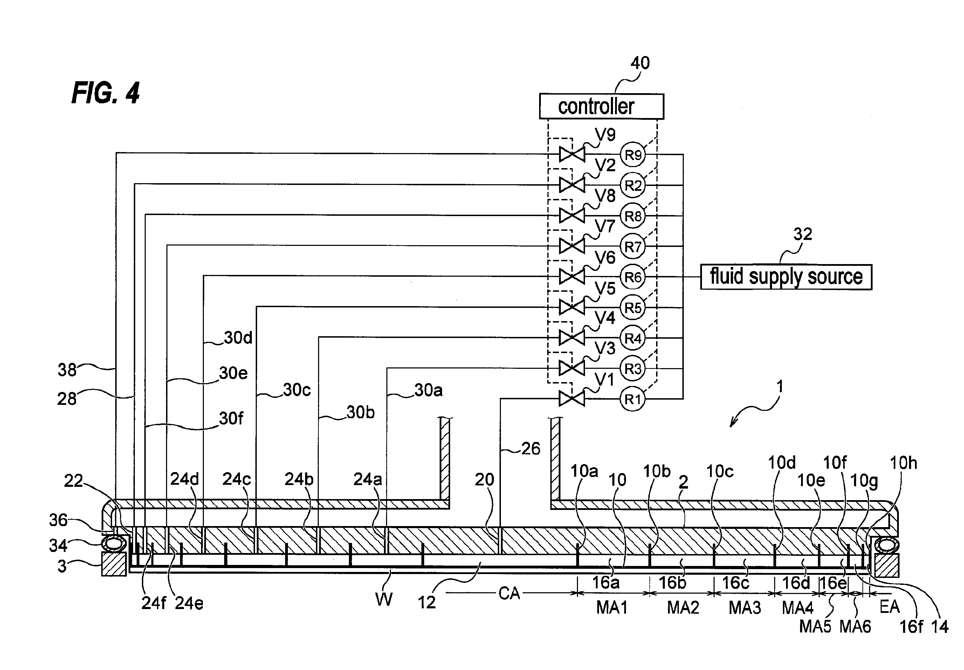

Next, the substrate holding apparatus 1 according to an embodiment of the present invention which is provided in the polishing apparatus shown in FIG. 3 will be described in detail with reference to FIG. 4.

As shown in FIG. 4, the substrate holding apparatus 1 basically comprises an apparatus body 2 for pressing the semiconductor wafer W against the polishing surface 101a, and a retainer ring 3 for directly pressing the polishing surface 101a. An elastic membrane 10 is provided on a lower surface of the apparatus body 2 to cover the lower surface of the apparatus body 2. The elastic membrane 10 has a plurality of (eight in the figure) circumferential walls (first to eighth circumferential walls) 10a, 10b, 10c, 10d, 10e, 10f, 10g and 10h, which are arranged concentrically and extend upward. By these concentric circumferential walls 10a 10b, 10c, 10d, 10e, 10f, 10g and 10h, a circular central pressure chamber 12 located at a central part of the elastic membrane 10, an annular edge pressure chamber 14 located at the outermost part of the elastic membrane 10, and six (in this example) annular intermediate pressure chambers (first to sixth intermediate pressure chambers) 16a, 16b, 16c, 16d, 16e and 16f located between the central pressure chamber 12 and the edge pressure chamber 14, are formed between an upper surface of the elastic membrane 10 and the lower surface of the apparatus body 2.

With this configuration, the semiconductor wafer W is held by the substrate holding apparatus 1 in such a state that there are eight divided pressurizing areas, on the elastic membrane 10, comprising a central pressurizing area CA corresponding to the central pressure chamber 12, an edge pressurizing area EA corresponding to the edge pressure chamber 14, and six annular intermediate pressurizing areas (first to sixth intermediate areas) MA1, MA2, MA3, MA4, MA5 and MA6 corresponding respectively to the intermediate pressure chambers 16a, 16b, 16c, 16d, 16e and 16f.

In this example, a radius of the central pressurizing area CA, i.e. a radius of the first circumferential wall 10a located at the innermost is set to be 30mm. The radius of the first circumferential wall 10a is a distance from the center of the elastic membrane 10 to the center of the cross-section of a rising portion of the first circumferential wall 10a. This holds true for the following respective circumferential walls 10b, 10c, 10d, 10e, 10f, 10g and 10h.

An area width of the first intermediate pressurizing area MA1 located at a central side of the elastic membrane 10, i.e. a difference between the radius of the first circumferential wall 10a located at the innermost and a radius of the second circumferential wall 10b located at the second from the inside, is set to be 30mm. The area width of the first intermediate pressurizing area MA1 is a radial area width of the first intermediate pressurizing area MA1. An area width of the second intermediate pressurizing area MA2 located at the second from the central side of the elastic membrane 10, i.e. a difference between the radius of the second circumferential wall 10b located at the second from the inside and a radius of the third circumferential wall 10c located at the third from the inside, is set to be 25mm. The area width of the second intermediate pressurizing area MA2 is a radial area width of the second intermediate pressurizing area MA2.

Similarly, an area width of the third intermediate pressurizing area MA3 located at the third from the central side of the elastic membrane 10 is set to be 25mm, and an area width of the fourth intermediate pressurizing area MA4 located at the fourth from the central side of the elastic membrane 10 is set to be 17mm. Further, an area width of the fifth intermediate pressurizing area MA5 located at the fifth from the central side of the elastic membrane 10 is set to be 13.5mm, and an area width of the sixth intermediate pressurizing area MA6 located at the sixth from the central side of the elastic membrane 10 is set to be 4.5mm. The area widths of the intermediate pressurizing areas MA3, MA4, MA5 and MA6 are radial area widths of the intermediate pressurizing areas MA3, MA4, MA5 and MA6 respectively.

The area width of the fourth intermediate pressurizing area MA4 is arbitrarily set in the range of not less than 2mm and not more than 20mm, and the area width of the fifth intermediate pressurizing area MA5 and the area width of the sixth intermediate pressurizing area MA6 are arbitrarily set in the range of not less than 2mm and not more than 15mm. Only one of the area widths of the fifth intermediate pressurizing area MA5 and the sixth intermediate pressurizing area MA6 may be arbitrarily set in the range of not less than 2mm and not more than 15mm. For example, the area width of the fifth intermediate pressurizing area MA5 may be arbitrarily set in the range of not less than 2mm and not more than 20mm and the area width of the sixth intermediate pressurizing area MA6 may be arbitrarily set in the range of not less than 2mm and not more than 15mm.

A passage 20 communicating with the central pressure chamber 12, a passage 22 communicating with the edge pressure chamber 14, and passages 24a, 24b, 24c, 24d, 24e and 24f communicating with the intermediate pressure chambers 16a, 16b, 16c, 16d, 16e and 16f respectively, are formed in the apparatus body 2. The respective passages 20, 22, 24a, 24b, 24c, 24d, 24e and 24f are connected via respective passages 26, 28, 30a, 30b, 30c, 30d, 30e and 30f to a fluid supply source 32. Further, opening and closing valves V1, V2, V3, V4, V5, V6, V7 and V8 and pressure regulators R1, R2, R3, R4, R5, R6, R7 and R8 are provided in the respective passages 26, 28, 30a, 30b, 30c, 30d, 30e and 30f.

Further, a retainer chamber 34 is formed immediately above the retainer ring 3, and the retainer chamber 34 is connected via a passage 36 formed in the apparatus body 2 and a passage 38 having an opening and closing valve V9 and a pressure regulator R9 to the fluid supply source 32. The pressure regulators R1, R2, R3, R4, R5, R6, R7, R8 and R9 have pressure adjusting function for adjusting pressures of the pressurized fluid supplied from the fluid supply source 32 to the pressure chambers 12, 14, 16a, 16b, 16c, 16d, 16e, 16f and the retainer chamber 34, respectively. The pressure regulators R1, R2, R3, R4, R5, R6, R7, R8 and R9 and the opening and closing valves V1, V2, V3, V4, V5, V6, V7, V8 and V9 are connected to a controller 40, and operations of the pressure regulators R1, R2, R3, R4, R5, R6, R7, R8 and R9 and the opening and closing valves V1, V2, V3, V4, V5, V6, V7, V8 and V9 are controlled by the controller 40.

According to the substrate holding apparatus 1 configured as shown in FIG. 4, by controlling pressures of the pressurized fluid supplied to the respective pressure chambers 12, 14, 16a, 16b, 16c, 16d, 16e and 16f in such a state that the semiconductor wafer W is held by the substrate holding apparatus 1, the semiconductor wafer W can be pressed against the polishing surface under different pressures at the respective pressurizing areas CA, EA, MA1, MA2, MA3, MA4, MA5 and MA6 on the elastic membrane 10 along a radial direction of the semiconductor wafer W. Thus, in the substrate holding apparatus 1, pressing forces for pressing the semiconductor wafer W against the polishing pad 101 can be adjusted at the respective areas of the semiconductor wafer W corresponding to the respective pressurizing areas CA, EA, MA1, MA2, MA3, MA4, MA5 and MA6 by adjusting pressures of the pressurized fluid supplied to the respective pressure chambers 12, 14, 16a, 16b, 16c, 16d, 16e and 16f defined between the apparatus body 2 and the elastic membrane 10. At the same time, a pressing force for pressing the polishing pad 101 by the retainer ring 3 can be adjusted by controlling pressure of the pressurized fluid supplied to the retainer chamber 34.

The apparatus body 2 is made of resin such as engineering plastics (e.g. PEEK), and the elastic membrane 10 is made of a highly strong and durable rubber material such as ethylene propylene rubber (EPDM), polyurethane rubber, silicone rubber, or the like.

The reason why the area width of the fourth intermediate pressurizing area MA4 is set to be not less than 2mm and not more than 20mm, 17.5mm in this example, and the area widths of the fifth intermediate pressurizing area MA5 and the sixth intermediate pressurizing area MA6 are set to be not less than 2mm and not more than 15mm, 13.5mm in the case of the fifth intermediate pressurizing area MA5 and 4.5mm in the case of the sixth intermediate pressurizing area MA6 in this example in the substrate holding apparatus 1, will be described below.

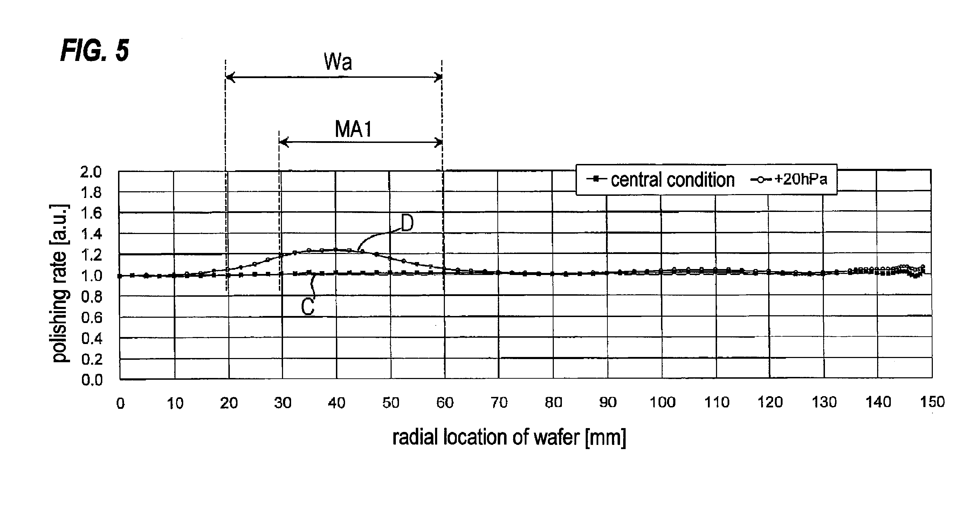

FIG. 5 is a graph showing the relationship between a polishing rate (arbitrary unit) and locations along a radial direction of the semiconductor wafer when the semiconductor wafer having a diameter of 300mm is practically polished while predetermined pressures of the pressurized fluid are applied to respective pressure chambers 12, 14, 16a, 16b, 16c, 16d, 16e and 16f by using the polishing apparatus shown in FIG. 3. In FIG. 5, the line C shows the relationship between a polishing rate (arbitrary unit) and locations along a radial direction of the semiconductor wafer under the condition (hereinafter referred to as central condition) that pressures of respective pressure chambers are adjusted so that polishing rates at respective pressurizing areas become substantially the same. The line D shows the relationship between a polishing rate (arbitrary unit) and locations along a radial direction of the semiconductor wafer under the condition that only a pressure of the pressurized fluid supplied to the first intermediate pressure chamber 16a corresponding to the first intermediate pressurizing area MA1 is increased so as to be higher by 20hPa than the pressure of the central condition.

From FIG. 5, it is understood that when, for example, only the pressure of the pressurized fluid supplied to the first intermediate pressure chamber 16a corresponding to the first intermediate pressurizing area MA1 is increased so as to be higher by 20hPa than the pressure of the central condition, this effect extends over a polishing rate responsive width Wa which is wider than the first intermediate pressurizing area MA1.

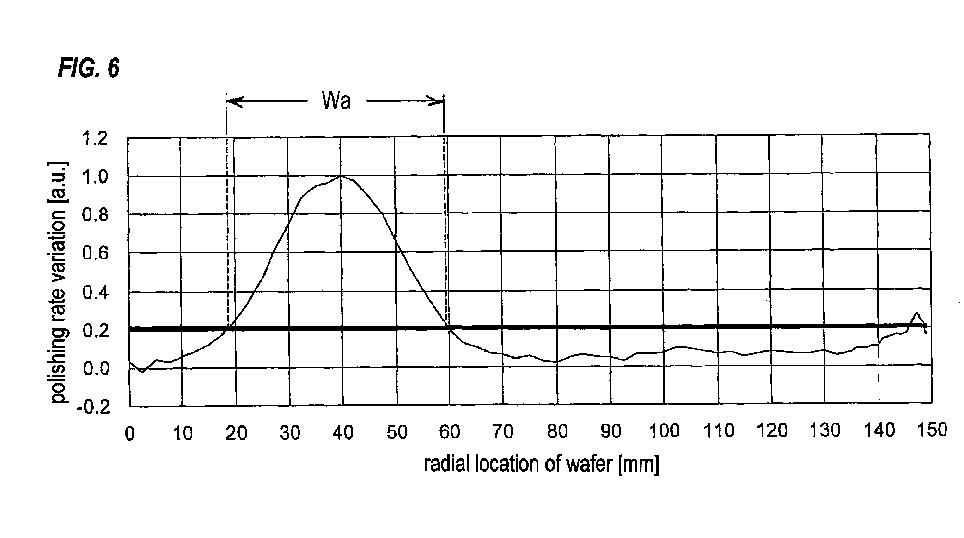

FIG. 6 is a graph showing differences, as polishing rate variation (arbitrary unit), obtained by subtracting a polishing rate indicated by line C from a polishing rate indicated by line D in FIG. 5, a maximum value of the polishing rate variation being defined as 1 to be a standard. Specifically, the polishing rate variation in FIG. 6 shows an amount of change in the polishing rate in the case where a predetermined pressure is changed from a pressure of the above central condition in a certain pressurizing area. The polishing rate variation when a predetermined pressure is changed from a certain pressure in a certain pressurizing area is calculated, and a radial area of the semiconductor wafer in which the polishing rate variation is not less than 20% and not more than 100% with respect to the maximum polishing rate variation to be a standard is defined as a polishing rate responsive width.

In FIGS. 5 and 6, the polishing rate responsive width is determined from the polishing results when the pressure is increased from the central condition. However, the polishing rate responsive width may be determined from the polishing results when the pressure is lowered from the central condition.

When the maximum polishing rate variation in the first intermediate pressurizing area MA1 is defined as 1 to be a standard and the polishing rate variation is not more than 20% of the maximum polishing rate variation (not more than 0.2 in FIG. 6), it is considered that the effect of this polishing rate variation on a polishing profile is suppressed within a tolerance. Therefore, a radial area of the semiconductor wafer in which the polishing rate variation is not less than 20% and not more than 100% (not less than 0.2 and not more than 1.0 in FIG. 6) with respect to the maximum polishing rate variation, i.e. 1 as the standard in the first intermediate pressurizing area MA1 is defined as a polishing rate responsive width. In the case of FIG. 6, the polishing rate responsive width Wa of the first intermediate pressurizing area MA1 is 41mm.

Similarly, the polishing rate responsive widths of other intermediate pressurizing areas MA2, MA3, MA4, MA5 and MA6 are measured and the measured values are as follows: The polishing rate responsive widths are 35mm in the case where only a pressure of the pressurized fluid supplied to the second intermediate pressure chamber 16b corresponding to the second intermediate pressurizing area MA2 is increased so as to be higher by 20hPa than the central condition, 37mm in the case where only a pressure of the pressurized fluid supplied to the third intermediate pressure chamber 16c corresponding to the third intermediate pressurizing area MA3 is increased so as to be higher by 20hPa than the central condition, 26mm in the case where only a pressure of the pressurized fluid supplied to the fourth intermediate pressure chamber 16d corresponding to the fourth intermediate pressurizing area MA4 is increased so as to be higher by 20hPa than the central condition, 27mm in the case where only a pressure of the pressurized fluid supplied to the fifth intermediate pressure chamber 16e corresponding to the fifth intermediate pressurizing area MA5 is increased so as to be higher by 20hPa than the central condition, and 25mm in the case where only a pressure of the pressurized fluid supplied to the sixth intermediate pressure chamber 16f corresponding to the sixth intermediate pressurizing area MA6 is increased so as to be higher by 20hPa than the central condition.

The relationship between the respective area widths of the respective intermediate pressurizing areas MA1, MA2, MA3, MA4, MA5 and MA6 and the polishing rate responsive widths obtained as described above, is shown in TABLE 1.

TABLE 1

| Area width [mm] | 30 | 25 | 25 | 17 | 13.5 | 4.5 |
|---|---|---|---|---|---|---|
| Polishing rate responsive width [mm] | 41 | 35 | 37 | 26 | 27 | 25 |

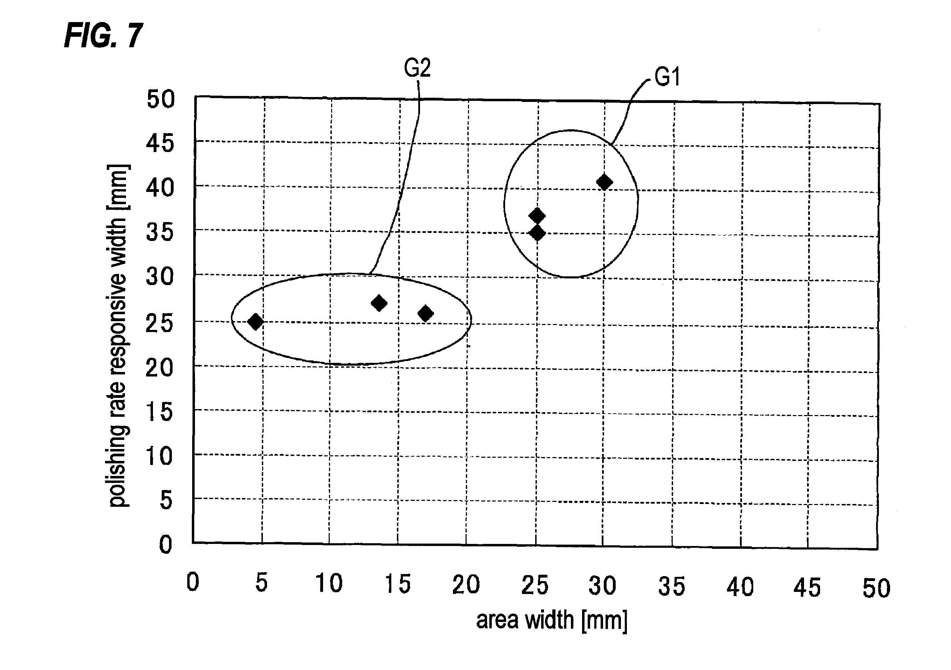

FIG.7, which is drawn based on TABLE 1, shows the relationship between the area widths of the intermediate pressurizing areas and the polishing rate responsive widths. From FIG. 7, it is understood that when the area width of the pressurizing area is not less than 25mm (group G1), the polishing rate responsive widths are such values as to add approximately 10mm to the respective area widths, and that even when the area width of the pressurizing area is smaller than 25mm (group G2), the minimum value of the polishing rate responsive widths is approximately 25mm. In group G2, even when the area width of the intermediate pressurizing area varies (decreases) among 17mm, 13.5mm and 4.5mm, the polishing rate responsive widths are 26mm, 27mm and 25mm, respectively, and thus nearly-unchanged. Thus, it is considered that the polishing rate responsive width does not change even when the area width of the intermediate pressurizing area is not more than 15mm.

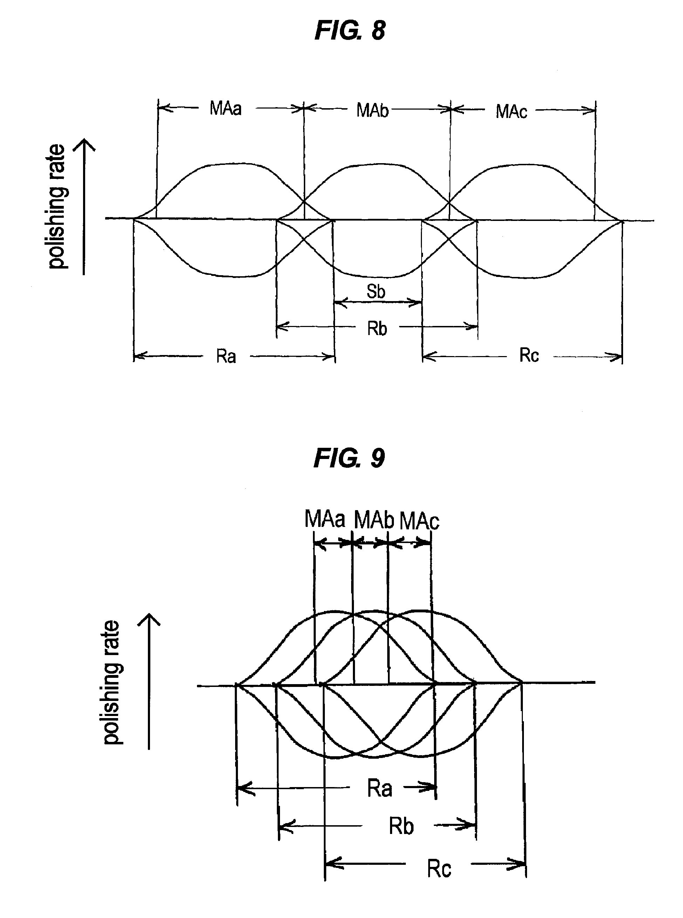

FIG. 8 shows the relationship between intermediate pressurizing areas MAa, MAb, MAc and polishing rate responsive widths Ra, Rb, Rc corresponding to the intermediate pressurizing areas MAa, MAb, MAc, in the case where the three intermediate pressurizing areas MAa, MAb, MAc have relatively wide area widths and are adjacent to each other. In FIG. 8, three convex solid lines above a horizontal line indicate respective polishing rates in the case where pressures of the respective areas are higher than those of the central condition, and three concave solid lines below the horizontal line indicate respective polishing rates in the case where pressures of the respective areas are lower than those of the central condition. In this case, in the central area of the intermediate pressurizing area MAb located in the middle, there is an area Sb which is not affected by the polishing rate responsive widths Ra and Rc corresponding to other intermediate pressurizing areas MAa and MAc. The inclination of the polishing rate of the area of the semiconductor wafer corresponding to the area Sb cannot be corrected even when pressures applied to the intermediate pressurizing areas MAa and MAc are changed.

FIG. 9 shows the relationship between intermediate pressurizing areas MAa, MAb, MAc and polishing rate responsive widths Ra, Rb, Rc corresponding to the intermediate pressurizing areas MAa, MAb, MAc, in the case where the three intermediate pressurizing areas MAa, MAb, MAc have relatively small area widths and are adjacent to each other. In FIG. 9, three convex solid lines above a horizontal line indicate respective polishing rates in the case where pressures of the respective areas are higher than those of the central condition, and three concave solid lines below the horizontal line indicate respective polishing rates in the case where pressures of the respective areas are lower than those of the central condition. In this case, the intermediate pressurizing area MAb located in the middle is affected by the polishing rate responsive widths Ra and Rc corresponding to other two intermediate pressurizing areas MAa and MAc. The inclination of the polishing rate of the area of the semiconductor wafer corresponding to the intermediate pressurizing area MAb can be corrected by changing pressures of the intermediate pressurizing areas MAa and MAc. Particularly, the intermediate pressurizing area is preferably divided into small areas in the vicinity of the edge of the semiconductor wafer.

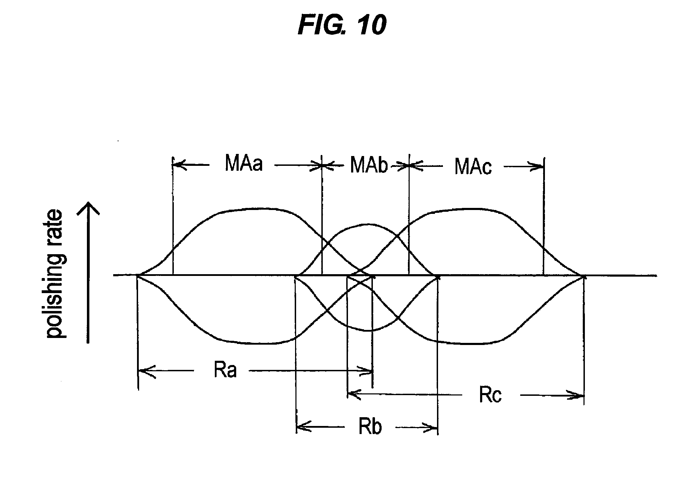

FIG. 10 shows the relationship between intermediate pressurizing areas MAa, MAb, MAc and polishing rate responsive widths Ra, Rb, Rc corresponding to the intermediate pressurizing areas MAa, MAb, MAc, in the case where an intermediate pressurizing area MAb has a relatively narrow area width and is located between the two adjacent intermediate pressurizing areas MAa, MAc which have relatively wide area widths. In FIG. 10, three convex solid lines above a horizontal line indicate respective polishing rates in the case where pressures of the respective areas are higher than those of the central condition, and three concave solid lines below the horizontal line indicate respective polishing rates in the case where pressures of the respective areas are lower than those of the central condition. In this case, the intermediate pressurizing area MAb located in the middle and having a relatively narrow area width is affected by the polishing rate responsive widths Ra and Rc corresponding to other two intermediate pressurizing areas MAa and MAc. The inclination of the polishing rate of the area of the semiconductor wafer corresponding to the intermediate pressurizing area MAb can be corrected by changing pressures of the intermediate pressurizing areas MAa and MAc. Thus, fine adjustment of polishing profile can be achieved by providing the intermediate pressurizing area MAb having a relatively narrow area width between the intermediate pressurizing areas MAa and MAc having relatively wide area widths.

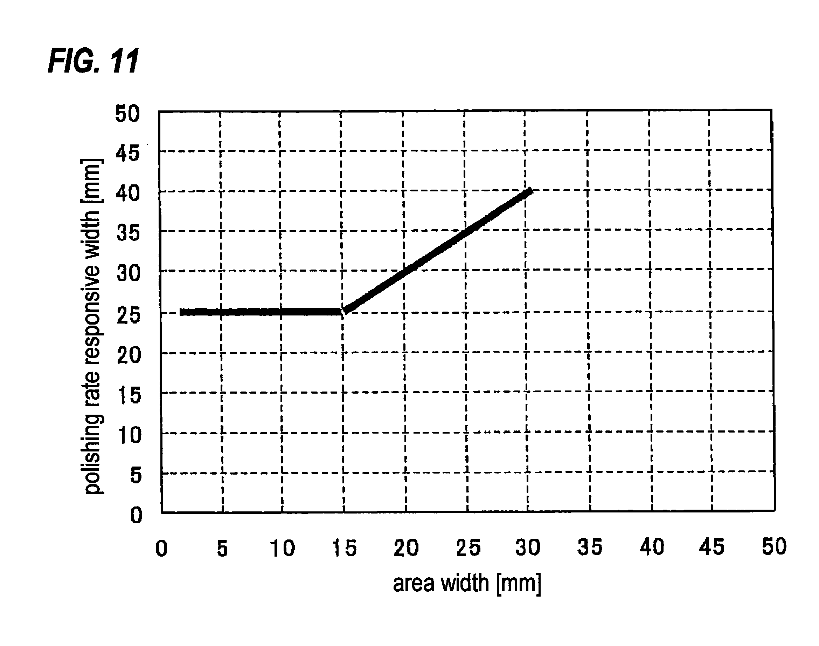

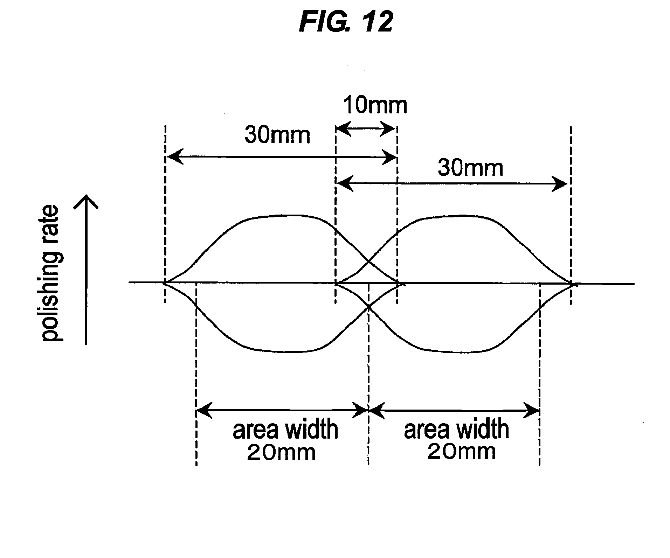

FIG. 11, which models FIG. 7, shows the relationship between the area widths of the intermediate pressurizing areas and the polishing rate responsive widths. In FIG. 11, the polishing rate responsive width of the intermediate pressurizing area having an area width of 20mm is 30mm. In the case where the intermediate pressurizing areas, whose area widths are 20mm and polishing rate responsive widths are 30mm, are adjacent to each other, the ratio at which the polishing rate responsive widths overlap each other (overlap ratio of polishing rate response) is approximately 33 (=10/30) (%), as shown in FIG. 12. In FIG. 12, two convex solid lines above a horizontal line indicate respective polishing rates in the case where pressures of the respective areas are higher than those of the central condition, and two concave solid lines below the horizontal line indicate respective polishing rates in the case where pressures of the respective areas are lower than those of the central condition.

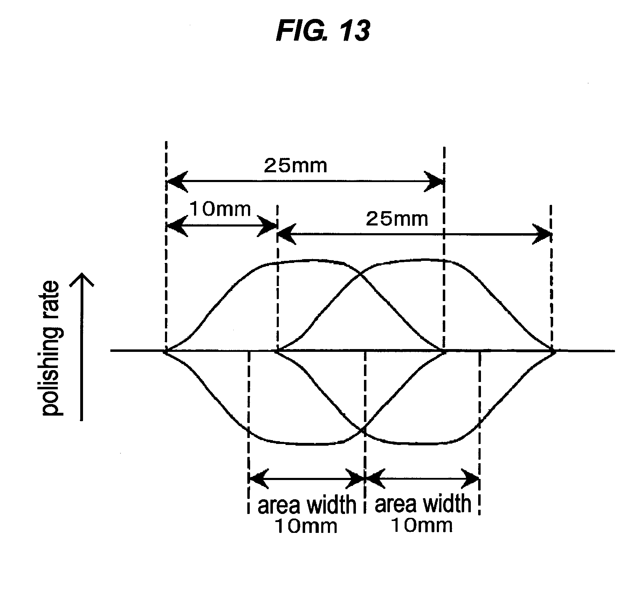

Further, in FIG. 11, the polishing rate responsive width of the intermediate pressurizing area having an area width of 10mm is 25mm. In the case where the intermediate pressurizing areas, whose area widths are 10mm and polishing rate responsive widths are 25mm, are adjacent to each other, the ratio at which the polishing rate responsive widths overlap each other (overlap ratio of polishing rate response) is 60 (=15/25) (%), as shown in FIG. 13. In FIG. 13, two convex solid lines above a horizontal line indicate respective polishing rates in the case where pressures of the respective areas are higher than those of the central condition, and two concave solid lines below the horizontal line indicate respective polishing rates in the case where pressures of the respective areas are lower than those of the central condition.

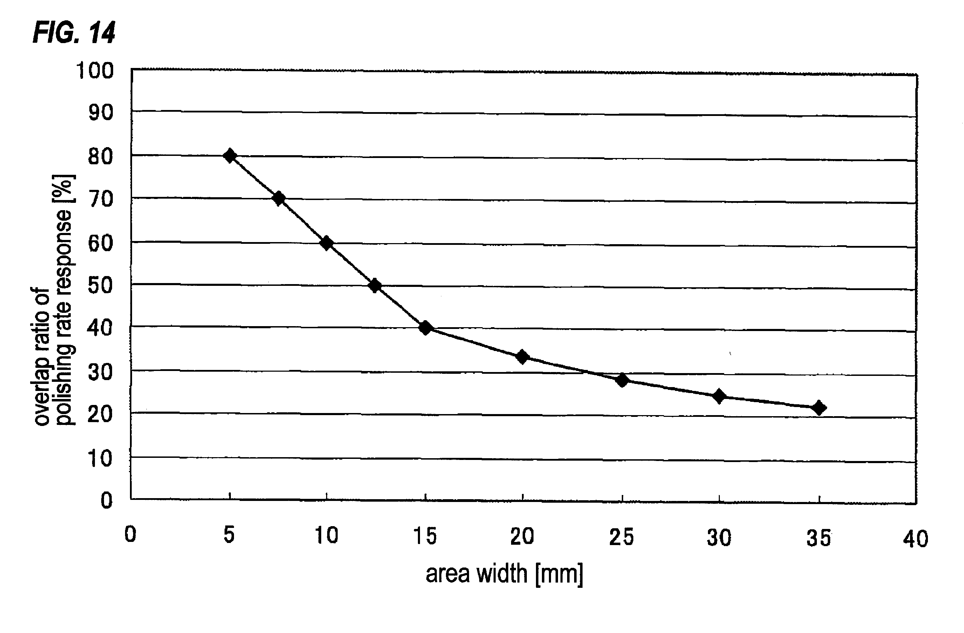

FIG. 14, which is drawn based on FIG. 11, shows the relationship between the area widths of the intermediate pressurizing areas and the overlap ratios of polishing rate response. From FIG. 14, it is understood that the polishing rate responsive width becomes no smaller than 25mm in the intermediate pressurizing area having the area width of not more than 15mm, and hence the ratio at which the polishing rate responsive widths overlap each other (overlap ratio of polishing rate response) becomes larger, and thus fine adjustment of polishing profile can be achieved in the intermediate pressurizing area having the area width of not more than 15mm. Further, it is understood that the ratio at which the polishing rate responsive widths overlap each other (overlap ratio of polishing rate response) is approximately 33% or higher and still relatively large also in the intermediate pressurizing area having the area width of not more than 20mm, and thus fine adjustment of polishing profile can be achieved in the intermediate pressurizing area having the area width of not more than 20mm. From FIG. 14, in the case where the area width is not more than 15mm, the ratio at which the polishing rate responsive widths overlap each other (overlap ratio of polishing rate response) is greatly changed, and thus the area width of not more than 15mm is taken as one of the area width set standards. Further, the ratio at which the polishing rate responsive widths overlap each other (overlap ratio of polishing rate response) becomes relatively large also in the area width of not more than 20mm obtained by adding a certain range to the area width of not more than 15mm, and thus the area width of not more than 20mm is also taken as one of the area width set standards.

Thus, in this example, in consideration of the thickness of the circumferential wall (approximately 1mm), the area widths of the fifth intermediate pressurizing area MA5 and the sixth intermediate pressurizing area MA6, which are located in the vicinity of the edge of the substrate such as a semiconductor wafer and need fine adjustment of polishing profile most, are set to be not less than 2mm and not more than 15mm. Specifically, the area width of the fifth intermediate pressurizing area MA5 is set to be 13.5mm, and the area width of the sixth intermediate pressurizing area MA6 is set to be 4.5mm. Further, the area width of the fourth intermediate pressurizing area MA4, which needs fine adjustment of polishing profile next to the fifth intermediate pressurizing area MA5 and the sixth intermediate pressurizing area MA6, is set to be not less than 2mm and not more than 20mm, specifically 17.5mm. The reason why the area width is set to be not less than 2mm is that the thickness of the circumferential wall (approximately 1mm) and the passage of the pressurized fluid (lower limit is approximately 1mm) are considered.

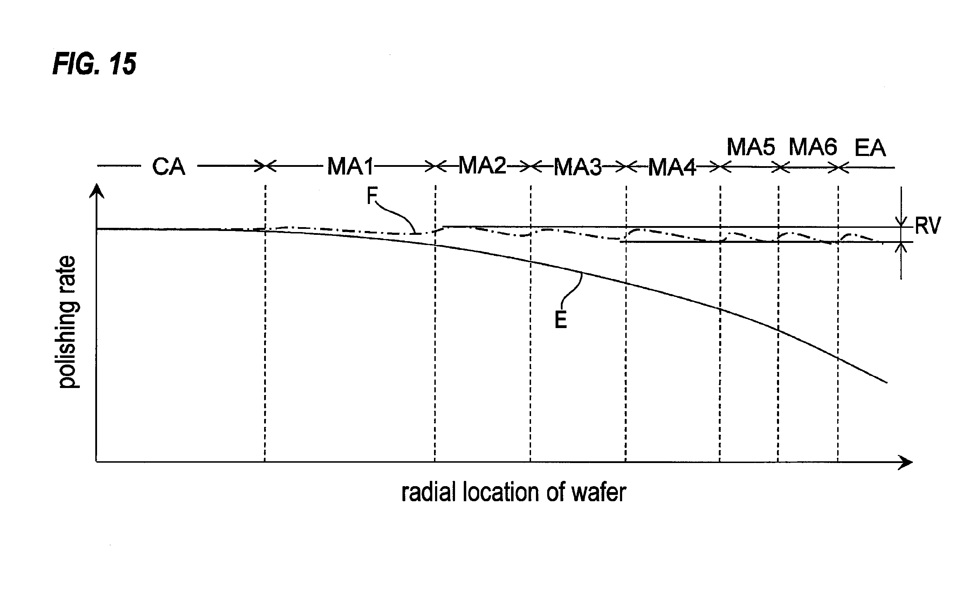

FIG. 15 shows the relationship between radial locations of the semiconductor wafer and a polishing rate when the semiconductor wafer having a diameter of 300mm is polished by using the polishing apparatus shown in FIG. 3. In FIG. 15, a solid line E indicates the case where the semiconductor wafer is polished while pressures of pressurized fluid supplied to the respective pressure chambers 12, 14, 16a, 16b, 16c, 16d, 16e and 16f are equalized. A dotted-dashed line F indicates the case where the semiconductor wafer is polished while pressures of pressurized fluid supplied to the intermediate pressure chambers 16a, 16b, 16c, 16d, 16e and 16f are adjusted. In FIG. 15, with respect to radial locations of the semiconductor wafer, areas CA, MA1, MA2, MA3, MA4, MA5, MA6 and EA along a radial direction of the semiconductor wafer, correspond to the respective pressurizing areas CA, MA1, MA2, MA3, MA4, MA5, MA6 and EA shown in FIG. 4.

From FIG. 15, it is understood that the polishing apparatus shown in FIG. 3 is used, and by adjusting pressures of pressurized fluid supplied to respective pressure chambers 12, 14, 16a, 16b, 16c, 16d, 16e and 16f and by using the elastic membrane which has adjusted radial area widths of respective pressurizing areas for pressing the semiconductor wafer, the range of polishing rate distribution (variation range of polishing rate) RV between a plurality of pressurizing areas of the semiconductor wafer and also in the respective pressurizing areas can be narrowed to enhance uniformity of the surface, being polished, of the semiconductor wafer and improve yield.

Next, the case where a semiconductor wafer having a diameter of 450mm is polished will be described. The standard thickness of the semiconductor wafer having a diameter of 450mm is assumed to be $925 \pm 25 \mu m$.

Then, the flexural rigidity D of a circular disc is expressed in the following formula.

$$D=Eh^3/12(1-\nu^2)$$

Here, E is Young's modulus, h is a disc thickness, and $\nu$ is Poisson's ratio. The flexural rigidity D of the circular disc is proportional to the cube of the disc thickness h.

In the case of the semiconductor wafer having a diameter of 300mm, the reason why the polishing rate responsive width does not become a certain value or less (25mm or less) even when the area width of the intermediate pressurizing area is narrowed, is due to the rigidity of the semiconductor wafer. The semiconductor wafer having a diameter of 450mm has a rigidity of cube of (925/775), i.e. approximately 1.7 times that of the semiconductor wafer having a diameter of 300mm.

Therefore, the area widths of 20mm, 15mm in the case of the semiconductor wafer having a diameter of 300mm, are equivalent to $20\times1.7=34mm$, $15\times1.7=26mm$, respectively in the case of the semiconductor wafer having a diameter of 450mm.

Accordingly, when the semiconductor wafer having a diameter of 450mm is polished by using the polishing apparatus shown in FIG. 3, the area width of the fourth intermediate pressurizing area MA4 corresponding to the fourth intermediate pressure chamber 16d is arbitrarily set in the range of not less than 2mm and not more than 34mm, and the area widths of the fifth intermediate pressurizing area MA5 and the sixth intermediate pressurizing area MA6 corresponding respectively to the fifth intermediate pressure chamber 16e and the sixth intermediate pressure chamber 16f are arbitrarily set in the range of not less than 2mm and not more than 26mm.

In more general description, when an area width of an intermediate pressurizing area in the case of a semiconductor wafer having a diameter of 300mm is EWa, an area width EWb of an intermediate pressurizing area in the case of a semiconductor wafer having a thickness t ($\mu$m), Young's modulus E (MPa) is expressed as $EWb=EWa\times(t/775)^3\times(E/194000)$.

Although certain preferred embodiments of the present invention have been shown and described in detail, it should be understood that various changes and modifications may be made without departing from the scope of the appended claims.

**Claims**

1.  An elastic membrane for use in a substrate holding apparatus for holding a substrate, said elastic membrane comprising:

    a plurality of concentrically circumferential walls configured to define a plurality of pressurizing areas for pressing the substrate, said plurality of pressurizing areas comprising a central pressurizing area located at a central part of said elastic membrane, an annular edge pressurizing area located at the outermost part of said elastic membrane, and a plurality of intermediate pressurizing areas located between said central pressurizing area and said annular edge pressurizing area;
    wherein an area width of at least one of said intermediate pressurizing areas is set in a range to allow a polishing rate responsive width not to vary even when the area width is varied.

2. The elastic membrane according to claim 1, wherein said polishing rate responsive width corresponds to a radial area of the substrate determined in each of said plurality of intermediate pressurizing areas; and

an absolute value of variation between a polishing rate when the substrate is polished under certain pressure condition and a polishing rate when the substrate is polished under pressure condition changed by a predetermined pressure from said certain pressure condition in each of said intermediate pressurizing areas is calculated, and the radial area of the substrate in which said absolute value of the polishing rate variation is not less than 20% and not more than 100% with respect to a maximum absolute value of the polishing rate variation in each of said intermediate pressurizing areas is defined as said polishing rate responsive width; and/or

wherein preferably said at least one of said intermediate pressurizing areas whose area width is set in the range to allow said polishing rate responsive width not to vary even when the area width is varied, comprises at least two of said plurality of intermediate pressurizing areas which are adjacent to each other.

3. The elastic membrane according to claim 1, wherein said elastic membrane is used for a substrate holding apparatus for holding a semiconductor wafer having a diameter of 300mm, and the area width of at least one of said intermediate pressurizing areas is set in a range of not less than 2mm and not more than 15mm;

wherein preferably the area widths of at least two of said intermediate pressurizing areas which are adjacent to each other, are set in the range of not less than 2mm and not more than 15mm, respectively.

4. The elastic membrane according to claim 1, wherein said elastic membrane is used for a substrate holding apparatus for holding a semiconductor wafer having a diameter of 300mm, and the area width of at least one of said intermediate pressurizing areas located at an outer circumferential side is set in a range of not less than 2mm and not more than 15mm, and the area width of said intermediate pressurizing area located at a radially inner side of said intermediate pressurizing area having the area width set in a range of not less than 2mm and not more than 15mm, is set in a range of not less than 2mm and not more than 20mm.

5. The elastic membrane according to claim 1, wherein said elastic membrane is used for a substrate holding apparatus for holding a semiconductor wafer having a diameter of 450mm, and the area width of at least one of said intermediate pressurizing areas is set in a range of not less than 2mm and not more than 26mm;

wherein preferably the area widths of at least two of said intermediate pressurizing areas which are adjacent to each other, are set in the range of not less than 2mm and not more than 26mm, respectively.

6. The elastic membrane according to claim 1, wherein said elastic membrane is used for a substrate holding apparatus for holding a semiconductor wafer having a diameter of 450mm, and the area width of at least one of said intermediate pressurizing areas located at an outer circumferential side is set in a range of not less than 2mm and not more than 26mm, and the area width of said intermediate pressurizing area located at a radially inner side of said intermediate pressurizing area having the area width set in the range of not less than 2mm and not more than 26mm, is set in a range of not less than 2mm and not more than 34mm.

7. An elastic membrane for use in a substrate holding apparatus for holding a semiconductor wafer having a thickness t ($\mu$m), Young's modulus E (MPa), said elastic membrane comprising:

a plurality of concentrically circumferential walls configured to define a plurality of pressurizing areas for pressing the semiconductor wafer, said plurality of pressurizing areas comprising a central pressurizing area located at a central part of said elastic membrane, an annular edge pressurizing area located at the outermost part of said elastic membrane, and a plurality of intermediate pressurizing areas located between said central pressurizing area and said annular edge pressurizing area;

wherein an area width of at least one of said intermediate pressurizing areas is set in a range to allow a polishing rate responsive width not to vary even when the area width is varied; and the area width of said at least one of said intermediate pressurizing areas is set in the range of not less than 2mm and not more than EWb (mm) defined in the following formula:

$$EWb = 15 \times (t/775)^3 \times (E/194000).$$

8. The elastic membrane according to claim 7, wherein said polishing rate responsive width corresponds to a radial area of the semiconductor wafer determined in each of said plurality of intermediate pressurizing areas; and

an absolute value of variation between a polishing rate when the semiconductor wafer is polished under certain pressure condition and a polishing rate when the semiconductor wafer is polished under pressure condition changed by a predetermined pressure from said certain pressure condition in each of said intermediate pressurizing areas is calculated, and the radial area of the semiconductor wafer in which said absolute value of the polishing rate variation is not less than 20% and not more than 100% with respect to a maximum absolute value of the polishing rate variation in each of said intermediate pressurizing areas is defined as said polishing rate responsive width.

9. The elastic membrane according to claim 7, wherein said at least one of said intermediate pressurizing areas whose area width is set in the range to allow said polishing rate responsive width not to vary even when the area width is varied, comprises at least two of said plurality of intermediate pressurizing areas which are adjacent to each other.

10. The elastic membrane according to claim 7, wherein said elastic membrane is used for a substrate holding apparatus for holding a semiconductor wafer having a diameter of 300mm, and the area width of at least one of said intermediate pressurizing areas is set in a range of not less than 2mm and not more than 15mm;
wherein preferably the area widths of at least two of said intermediate pressurizing areas which are adjacent to each other, are set in the range of not less than 2mm and not more than 15mm, respectively.

11. The elastic membrane according to claim 7, wherein said elastic membrane is used for a substrate holding apparatus for holding a semiconductor wafer having a diameter of 300mm, and the area width of at least one of said intermediate pressurizing areas located at an outer circumferential side is set in a range of not less than 2mm and not more than 15mm, and the area width of said intermediate pressurizing area located at a radially inner side of said intermediate pressurizing area having the area width set in a range of not less than 2mm and not more than 15mm, is set in a range of not less than 2mm and not more than 20mm.

12. The elastic membrane according to claim 7, wherein said elastic membrane is used for a substrate holding apparatus for holding a semiconductor wafer having a diameter of 450mm, and the area width of at least one of said intermediate pressurizing areas is set in a range of not less than 2mm and not more than 26mm;
wherein preferably the area widths of at least two of said intermediate pressurizing areas which are adjacent to each other, are set in the range of not less than 2mm and not more than 26mm, respectively.

13. The elastic membrane according to claim 7, wherein said elastic membrane is used for a substrate holding apparatus for holding a semiconductor wafer having a diameter of 450mm, and the area width of at least one of said intermediate pressurizing areas located at an outer circumferential side is set in a range of not less than 2mm and not more than 26mm, and the area width of said intermediate pressurizing area located at a radially inner side of said intermediate pressurizing area having the area width set in a range of not less than 2mm and not more than 26mm, is set in a range of not less than 2mm and not more than 34mm.

14. A substrate holding apparatus for holding a substrate to be polished and pressing the substrate against a polishing surface, comprising:

an elastic membrane;
an apparatus body for holding said elastic membrane;
a plurality of pressure chambers partitioned by a plurality of concentrically circumferential walls of said elastic membrane between said elastic membrane and a lower surface of said apparatus body, the substrate being held by a lower surface of said elastic membrane and being pressed against the polishing surface with a fluid pressure by supplying a pressurized fluid to said plurality of pressure chambers;
said plurality of concentrically circumferential walls being configured to define a plurality of pressurizing areas for pressing the substrate, said plurality of pressurizing areas comprising a central pressurizing area located at a central part of said elastic membrane, an annular edge pressurizing area located at the outermost part of said elastic membrane, and a plurality of intermediate pressurizing areas located between said central pressurizing area and said annular edge pressurizing area;
wherein an area width of at least one of said intermediate pressurizing areas is set in a range to allow a polishing rate responsive width not to vary even when the area width is varied.

15. A substrate holding apparatus for holding a semiconductor wafer having a thickness t ($\mu$m), Young's modulus E (MPa) and pressing the semiconductor wafer against a polishing surface, comprising:

an elastic membrane;
an apparatus body for holding said elastic membrane;

a plurality of pressure chambers partitioned by a plurality of concentrically circumferential walls of said elastic membrane between said elastic membrane and a lower surface of said apparatus body, the semiconductor wafer being held by a lower surface of said elastic membrane and being pressed against the polishing surface with a fluid pressure by supplying a pressurized fluid to said plurality of pressure chambers;

said plurality of concentrically circumferential walls being configured to define a plurality of pressurizing areas for pressing the semiconductor wafer, said plurality of pressurizing areas comprising a central pressurizing area located at a central part of said elastic membrane, an annular edge pressurizing area located at the outermost part of said elastic membrane, and a plurality of intermediate pressurizing areas located between said central pressurizing area and said annular edge pressurizing area;

wherein an area width of at least one of said intermediate pressurizing areas is set in a range to allow a polishing rate responsive width not to vary even when the area width is varied; and the area width of said at least one of said intermediate pressurizing areas is set in the range of not less than 2mm and not more than EWb (mm) defined in the following formula:

$$EWb=15\times(t/775)^3 \times (E/194000).$$

**FIG. 1**

FIG. 2

EP 2 703 122 A2

FIG. 3

FIG. 4

EP 2 703 122 A2

## FIG. 5

EP 2 703 122 A2

FIG. 6

# FIG. 7

EP 2 703 122 A2

## FIG. 8

## FIG. 9

# FIG. 10

# FIG. 11

## FIG. 12

# FIG. 13

FIG. 14

**FIG. 15**

CA  MA1  MA2  MA3  MA4  MA5  MA6  EA

RV

E

F

polishing rate

radial location of wafer

**REFERENCES CITED IN THE DESCRIPTION**

**Patent documents cited in the description**

- JP 2009131920 A